# EUROPÄISCHE PATENTANMELDUNG

(11) **EP 0 753 726 A1**
(43) Veröffentlichungstag der Anmeldung: **15.01.1997**
(21) Anmeldenummer: 96103756.1
(22) Anmeldetag: 11.03.1996
(51) Int. Cl.: G01K 7/00

(54) **Anordnung zur Ermittlung eines mittels eines Sensors gemessenen Parameters**

(30) Priorität: 11.07.1995 CH 2035/95
(71) Anmelder: Landis & Gyr Technology Innovation AG, 6301 Zug (CH)
(72) Erfinder: Jevgenij, Mannhart, 6330 Cham (CH)

(57) **Zusammenfassung**

Ein in einem Phasenregelkreis (17) mit einem ersten Eingang (19a) eines Phasenkomparators (19) verbundener Ausgang (18a) eines spannungsgesteuerten Oszillators (18) ist über einen Vorwiderstand (R_{V}) einerseits mit einem zweiten Eingang (19b) des Phasenkomparators (19) und andereseits mit einem Anschluss (21a) eines Resonanzkreises (21) verbunden. Ein Ausgang (19c) des Phasenkomparators (19) ist über ein Tiefpassfilter (22) mit einem Steuereingang (18b) des spannungsgesteuerten Oszillators (18) verbunden. Ein Kondensator (C) oder eine Induktivität (L), die beide zusammen den Resonanzkreis (21) bilden, ist ein Teil des Sensors (24).
Die Anordnung ist langzeitstabil, besteht aus wenigen Komponenten und benötigt wenig Lötstellen.

## Beschreibung

Die Erfindung bezieht sich auf eine Anordnung zur Ermittlung eines mittels eines Sensors gemessenen Parameters gemäss dem Oberbegriff des Anspruchs 1.

Der Sensor ist z. B. ein Temperatursensor. In diesem Fall dient die Anordnung zur Ermittlung der mittels des Temperatursensors gemessenen Temperatur.

Bekannt ist der innere Aufbau von Phasenregelkreisen, die als PLL-Bauelemente ("Phase Locked Loop") im Handel erhältlich sind und z. B. unter anderem von der Firma National Semiconductor Corporation, 2900 Semiconductor Drive, Santa Clara, Kalifornien 95051, unter der Typenbezeichnung 74HC/HCT4046A geliefert werden und zu denen ein Datenblatt gehört, welches in einem Datenbuch "High-Speed CMOS Family" veröffentlicht wurde.

Der Erfindung liegt die Aufgabe zugrunde, eine Anordnung der eingangs genannten Art zu realisieren, welche langzeitstabil ist, aus wenigen Komponenten besteht, bei einer Montage, z. B. auf eine gedruckte Schaltung, wenig Lötstellen benötigt und ein anloges sowie digitales Ausgangsignal aufweist als Messwert für einen mittels des Sensors gemessenen physikalischen Parameter, z. B. eine Temperatur.

Die genannte Aufgabe wird erfindungsgemäss durch die im Kennzeichen des Anspruchs 1 angegebenen Merkmale gelöst. Vorteilhafte Ansgestaltungen der Erfindung ergeben sich aus den abhängigen Ansprüchen.

Ein Ausführungsbeispiel der Erfindung ist in der Zeichnung dargestellt und wird im folgenden näher beschrieben.

Es zeigen:
Fig. 1 ein Blockschaltbild einer erfindungsgemässen Anordnung und
Fig. 2 ein Blockschaltbild eines käuflichen PLL-Bauelementes des Typs 74HC/HCT4046A mit seinen Beschaltungs-Bauteilen.

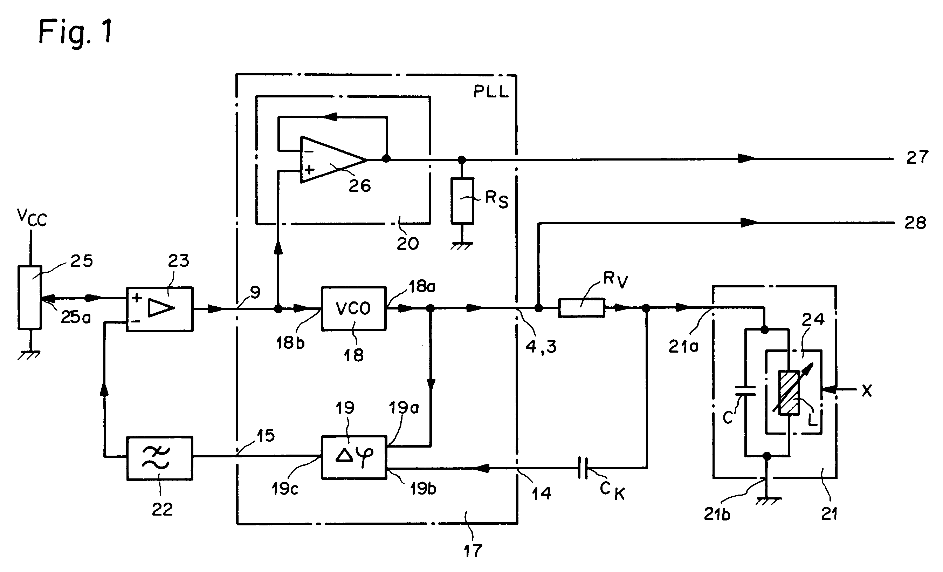

In der erfindungsgemässen Anordnung wird zur Niedrighaltung der Anzahl Bauelemente vorzugsweise ein käuflicher, als integrierte Schaltung ausgebildeter Phasenregelkreis 17, ein sogenanntes PLL-Bauelement (Phase Locked Loop), z. B. vom Typ 74HC/HCT4046A, verwendet. Das letztere besitzt 16 Anschlussbeine, die fortlaufend von 1 bis 16 durchnummeriert sind. Der Phasenregelkreis 17 enthält in jedem Fall einen spannungsgesteuerten Oszillator 18, auch VCO (Voltage Controlled Oscillator) genannt, einen Phasenkomparator 19 und einen mit einen Lastwiderstand R_{S} belasteten Spannungsfolger 20 (siehe Fig. 1). Im Phasenregelkreis 17 ist ein Ausgang 18a des spannungsgesteuerten Oszillators 18 mit einem ersten Eingang 19a des Phasenkomparators 19 verbunden und über einen Vorwiderstand R_{V} einerseits mit einem zweiten Eingang 19b des Phaserkomparators 19 und andererseits mit einem ersten Anschluss 21a eines Resonanzkreises 21 verbunden, dessen zweiter Anschluss 21b an Masse liegt. Der Resonanzkreis 21 ist vorzugsweise ein Parallresonanzkreis. In diesem Fall sind der Kondensator C und die Induktivität L parallelgeschaltet, was in der Fig. 1 angenommen wurde. Ein Ausgang 19c des Phasenkomparators 19 ist über ein Tiefpassfilter 22 mit einem Steuereingang 18b des spannungsgesteuerten Oszillators 18 verbunden. Der Ausgang des Tiefpassfilters 22 ist dabei entweder unmittelbar oder, wie in der Fig. 1 dargestellt, über ein nachgeschaltetes Subtraktionsglied 23 auf den Steuereingang 18b geführt. Ein Kondensator C oder eine Induktivität L, die beide zusammen den Resonanzkreis 21 bilden, ist ein Teil eines Sensors 24. Ein dem Kondensator C oder der Induktivität L zugehöriger Kapazitäts- bzw. Induktivitätswert ist eine Funktion, vorzugsweise eine lineare Funktion, eines vom Sensor 24 gemessenen Parameters x. D. h.: Der vom Sensor 24 emittelte Wert des Parameters x ist im letzteren Fall proportional dem Kapazitätswert des Kondensators C bzw. proportional dem Induktivitätswert der Induktivität L. In der Fig. 1 wurde letzteres angenommen, was symbolisch durch eine variable Induktivität L angedeutet ist. Der Parameter x ist z. B. eine Temperatur.

Das Subtraktionsglied 23 ist vorzugsweise ein Differenzverstärker, dessen invertierender Eingang mit dem Ausgang des Tiefpassfilters 22 verbunden ist, der dem Phasenregelkreis 17 einen Phasen-Istwert liefert. Ein Abgriff 25a eines von einer Gleichspannung V_{CC} gespeisten Potentiometers 25 ist mit einem nichtinvertierenden Eingang des Subtraktionsgliedes 23 bzw. des Differenzverstärkers verbunden. Das Potentiometer 25 liefert dem Phasenregelkreis 17 einen konstanten, zu Eichzwecken einstellbaren Phasen-Sollwert. Der Spannungsfolger 20 besitzt einen Verstärkungsfaktor "Eins'', einen hochohmigen Eingangswiderstand, einen niederohmigen Ausgangswiderstand und arbeitet als Impedanzwandler. Er besteht z. B. aus einem Operationsverstärker 26, dessen Ausgang mit einem invertierenden Eingang des Operationsverstärkers 26 verbunden ist, während dessen nichtinvertierender Eingang einen Eingang des Spannungsfolgers 20 bildet. Der Lastwiderstand R_{S} ist zwischen dem Ausgang des letzteren und Masse angeordnet. Der mit dem Lastwiderstand R_{S} belastete Ausgang des Spannungsfolgers 20 bildet einen Analogausgang 27 der erfindungsgemässen Anordnung. Seine Ausgangsspannung ist proportional dem Induktivitätswert der Induktivität L (in Fig. 1) bzw. dem Kapazitätswert des Kondensators C und damit proportional dem vom Sensor 24 gemessenen Paramater x. Der Ausgang 18a des spannungsgesteuerten Oszillators 18 ist zusätzlich mit einem Ausgang 28 der erfindungsgemässen Anordnung verbunden, der einen Digitalausgang derselben bildet. Die Frequenz seines Ausgangssignals ist proportional dem Induktivitätswert der Induktivität L (in Fig. 1) bzw. dem Kapazitätswert des Kondensators C und damit proportional dem vom Sensor 24 gemessenen Paramater x.

Bei kleinen Spannungssignalen ist der Ausgang des spannungsgesteuerten Oszillators 18 vorzugsweise über den Vorwiderstand R_{V} und einem diesen nachgeschalteten Kondensator C_{K} mit dem zweiten Eingang 19b des Phasenkomparators 19 verbunden. Bei grossen Spannungssignalen ist der Kondensator C_{K} nicht erforderlich, so dass er in diesem Fall weggelassen werden kann.

Die Funktion eines PLL-Phasenregelkreises ist allgemein bekannt, so dass sie hier nicht näher beschrieben wird. Es sei nur erwähnt, dass ein Mittelwert einer im Phasenkomparator 19 ermittelte Differenz der Phasen der Ausgangsspannung des spannungsgesteuerten Oszillators 18 und der Spannung über den Resonanzkreis 21 mittels des Phasenregelkreises 17 aufeinen Wert geregelt wird, der gleich dem mittels des Potentiometers 25 eingestellten Sollwert ist und z. B. gleich Null ist. In diesem Fall ist die Frequenz der Ausgangsspannung des spannungsgesteuerten Oszillators 18 gleich der Resonanzfrequenz des Resonanzkreises 21. Die Messung des Parameters x erfolgt somit immer bei dieser Resonanzfrequenz, so dass die Anordnung langzeitstabil ist, da nicht in einer der Flanken der Resonanzkurve gemessen wird. Die Fabrikation ist einfach, da als Bestückung nur wenige Bauelemente erforderlich sind und dementsprechend nur relativ wenige Lötstellen vorhanden sind. Der obenerwähnte Mittelwert der Phasendifferenz wird mittels des Tiefpassfilters 22 erzeugt.

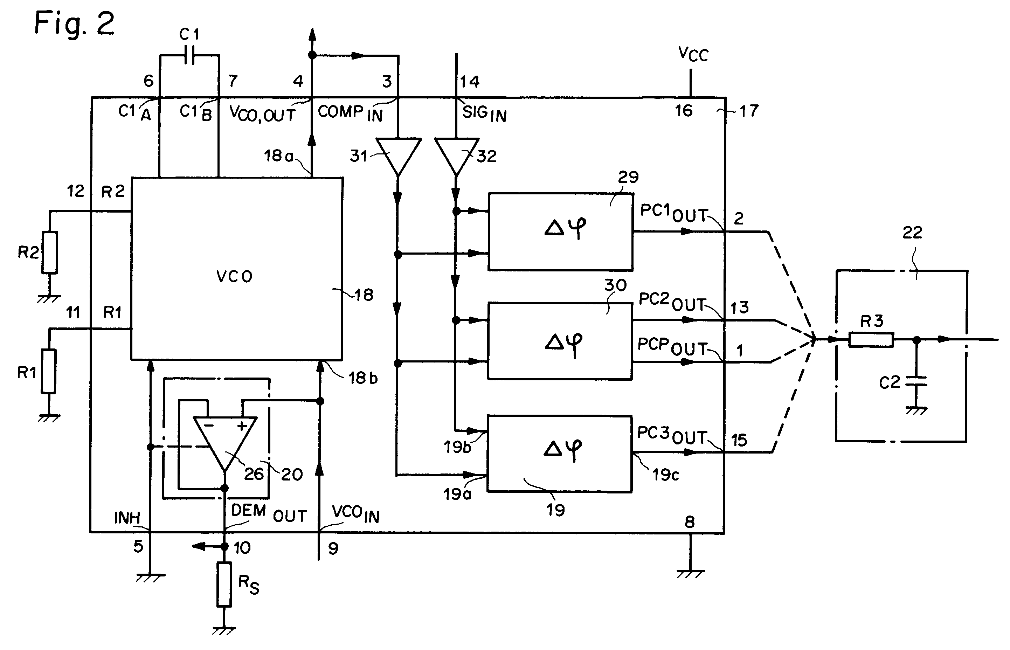

Der innere Aufbau des käuflichen Phasenregelkreises 17 ist mit seiner Bestückung und dem angeschlossenen Tiefpassfilter 22 aus der Fig. 2 ersichtlich. Er enthält zusätzlich zum Phasenkomparator 19 noch zwei weitere Phasenkomparatoren 29 und 30, die anstelle des Phasenkomparators 19 in der erfindungsgemässen Anordnung verwendet werden können. Vorzugsweise wird jedoch der Phasenkompatrator 19 verwendet. Im Phasenregelkreis 17 sind ausserdem noch zwei Pufferverstärker 31 und 32 vorhanden. Die Anschlussbeine 11, 12 und 10 des Phasenregelkreises 17 liegen über je einen Widerstand R1 bzw. R2 bzw. den Widerstand R_{S} extern an Masse, während seine Anschlussbeine 3 und 4 unmittelbar und seine Anschlussbeine 6 und 7 über einen Kondensator C1 miteinander verbunden sind. Die Anschlussbeine 5 und 8 liegen an Masse, während das Anschlussbein 16 von der Gleichspannung V_{CC} gespeist ist. Der Kapazitätswert des Kondensators C1 bestimmt die mittlere Frequenz des spannungsgesteuerten Oszillators 18, die gleich der mittleren Frequenz und somit gleich der Resonanzfrequenz des Resonanzkreises 21 ist. Sie liegt zwischen einer maximal zulässigen Frequenz fₘₐₓ und einer minimal zulässigen Frequenz fₘᵢₙ. Der Ausgang 18a des spannungsgesteuerten Oszillators 18 ist über die Anschlussbeine 4 und 3 sowie dem Pufferverstärker 31 mit ersten Eingängen der drei Phasenkomparatoren 19, 29 und 30 verbunden, insbesondere mit dem ersten Eingang 19a des ersteren. Ein Eingang 14 des Phasenregelkreises 17 ist über den Pufferverstärker 32 mit zweiten Eingängen der drei Phasenkomparatoren 19, 29 und 30 verbunden, insbesondere mit dem zweiten Eingang 19b des ersteren. Der Ausgang 18a des spannungsgesteuerten Oszillators 18 ist gemäss
Fig. 1 über R_{V} oder über R_{V} und C_{K} mit dem Anschlussbein 14 des Phasenregelkreises 17 und damit über den Pufferverstärker 32 auch mit dem zweiten Eingang 19b des Phasenkomparators 19 verbunden. Die Ausgänge der Phasenkomparatoren 29 und 30 sind auf die Anschlussbeine 2, 13 und 1 des Phasenregelkreises 17 geführt, welche extern nicht angeschlossen sind, wenn die Phasenkomparatoren 29 und 30 nicht verwendet werden. Der Phasenkomparator 30 besitzt zwei Ausgänge, während die Phasenkomparatoren 19 und 29 nur je einen Ausgang aufweisen. Der Ausgang 19c des Phasenkomparators 19 ist mit dem Anschlussbein 15 des Phasenregelkreises 17 verbunden, welcher extern auf den Eingang des Tiefpassfilters 22 geführt ist. Das Anschlussbein 9 des Phasenregelkreises 17 ist intern im letzteren auf den Steuereingang 18b des spannungsgesteuerten Oszillators 18 und auf den Eingang des Spannungsfolgers 20 geführt. Das Tiefpassfilter 22 ist z. B. ein an sich bekanntes RC-Tiefpassfilter, welches aus einem Widerstand R3 und einem Kondensator C2 besteht (siehe Fig. 2). Dabei bildet ein gemeinsamer Anschluss der beiden letzteren ein Ausgang des Tiefpassfilters 24, während ein zweiter Anschluss des Kondensators C2 an Masse liegt und ein zweiter Anschluss des Widerstandes R3 einen Eingang des Tiefpassfilters 22 bildet.

## Patentansprüche

1. Anordnung zur Ermittlung eines mittels eines Sensors (24) gemessenen Parameters (x), dadurch gekennzeichnet, dass ein in einem Phasenregelkreis (17) mit einem ersten Eingang (19a) eines Phasenkomparators (19) verbundener Ausgang (18a) eines spannungsgesteuerten Oszillators (18) über einen Vorwiderstand (R_{V}) einerseits mit einem zweiten Eingang (19b) des Phasenkomparators (19) und andereseits mit einem ersten Anschluss (21a) eines Resonanzkreises (21) verbunden ist, dessen zweiter Anschluss (21b) an Masse liegt, dass ein Ausgang (19c) des Phasenkomparators (19) über ein Tiefpassfilter (22) mit einem Steuereingang (18b) des spannungsgesteuerten Oszillators (18) verbunden ist und dass ein Kondensator (C) oder eine Induktivität (L), die beide zusammen den Resonanzkreis (21) bilden, ein Teil des Sensors (24) ist und ein zugehöriger Kapazitätsbeziehungsweise Induktivitätswert eine Funktion des vom Sensor (24) gemessenen Parameters (x) ist.

2. Anordnung nach Anspruch 1, dadurch gekennzeichnet, dass der Resonanzkreis (21) ein Parallelresonanzkreis ist.

3. Anordnung nach Anspruch 1 oder 2, dadurch gekennzeichnet, dass der Ausgang (18a) des spannungsgesteuerten Oszillators (18) über den Vorwiderstand (R_{V}) und einem diesen nachgeschalteten Kondensator (C_{K}) mit dem zweiten Eingang (19b) des Phasenkomparators (19) verbunden ist.

4. Anordnung nach einem der Ansprüche 1 bis 3, dadurch gekennzeichnet, dass das Tiefpassfilter (22) über ein nachgeschaltetes Subtraktionsglied (23) mit dem Steuereingang (18b) des spannungsgesteuerten Oszillators (18) verbunden ist.

5. Anordnung nach Anspruch 4, dadurch gekennzeichnet, dass das Subtraktionsglied (23) ein Differenzverstärker ist, dessen invertierender Eingang mit einem Ausgang des Tiefpassfilters (22) verbunden ist, während ein Abgriff (25a) eines von einer Gleichspannung (V_{CC}) gespeisten Potentiometers (25) mit einem nichtinvertierenden Eingang des Differenzverstärkers verbunden ist.
